# EUROPEAN PATENT SPECIFICATION

(11) **EP 0 338 312 B1**
(45) Date of publication and mention of the grant of the patent: **13.01.1993**
(21) Application number: 89105833.1
(22) Date of filing: 03.04.1989
(51) Int. Cl.: H01L 29/72, H01L 29/08, H01L 27/12

(54) **Insulated gate bipolar transistor**
Bipolarer Transistor mit isolierter Steuerelektrode
Transistor bipolaire à grille isolée

(30) Priority: 01.04.1988 JP 78028/88
(43) Date of publication of application: 25.10.1989
(73) Proprietor: HITACHI, LTD., Chiyoda-ku, Tokyo 101 (JP)
(72) Inventor: Sakurai, Naoki, Hitachi-shi (JP); Mori, Mutsuhiro, Hitachi-shi (JP); Tanaka, Tomoyuki, Hitachi-shi (JP); Yasuda, Yasumichi, Hitachi-shi (JP); Nakano, Yasunori, Hitachi-shi (JP); Yatsuo, Tsutomu, Hitachi-shi (JP)
(74) Representative: Beetz & Partner Patentanwälte

(56) References cited:
- EP-A- 0 111 803
- EP-A- 0 111 804
- GB-A- 2 088 631
- TECHNICAL DIGEST OF THE INTERNATIONAL ELECTRON DEVICES MEETING, Washington, DC, 1st-4th December 1985, pages 724-727, IEEE, New York, US; H.W. BECKE: "Approaches to isolation in high voltage integrated circuits"
- ELECTRO AND MINI/MICRO NORTHEAST, New York, 23rd-25th April 1985, pages 1-3, New York, US; P.W. SHACKLE: "Custom high voltage integrations for industry"
- PATENT ABSTRACTS OF JAPAN, vol. 10, no. 175 (E-413)[2231], 20th June 1986; & JP-A-61 24 278
- PATENT ABSTRACTS OF JAPAN, vol. 10, no. 129 (E-403)[2186], 14th May 1986; & JP-A-60 260 152

## Description

### BACKGROUND OF THE INVENTION

The present invention relates to a semiconductor device and more particularly to a semiconductor device that is suitable for integration.

In recent years, an insulated gate bipolar transistor (hereinafter referred to as IGBT) has attracted considerable attention as a semiconductor device that is capable of controlling relatively large current.

One example of the conventional IGBT structures is disclosed in JP-A-57-120369 in which one main electrode (cathode) and a control electrode are formed on the main surface of a substrate whereas the other main electrode (anode) is formed on the bottom surface of the substrate. Such a structure is difficult to integrate along with several other devices on the same substrate since the main electrodes are formed on both surfaces of the substrate.

It is desired for integration to form all three terminals of IGBT on the same surface. Such a lateral IGBT structure is proposed in USP 4,364,073 and JP-A-59-132667. Fig. 9 shows this structure.

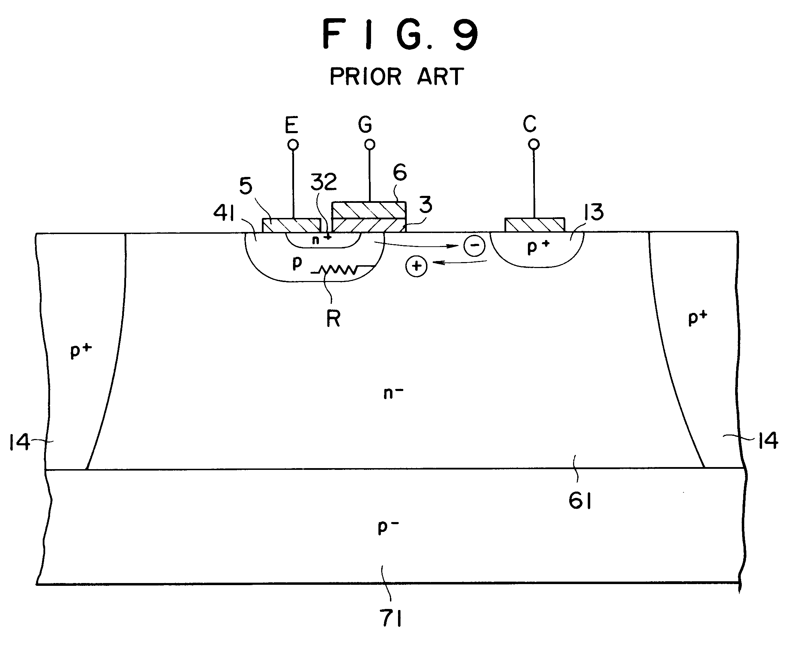

As seen from Fig. 9, a player 41 is formed in an n⁻-layer 61 that is formed in a p⁻-semiconductor substrate 71, and further an n⁺-layer 32 is formed in p-layer 41. Formed in n⁻-layer 61 is a p⁺-layer 13 distinatly from p⁻layer 41. N⁺-layer 32 and p⁻layer 41 are short-circuited by an emitter electrode 5. A gate electrode 6 is provided on part of the surface of p⁻ layer 41 through a gate insulating film 3 in such a way that it covers parts of n⁺-layer 32 and n⁻-layer 61. The provision of p⁺-layers 14 serves to electrically separate that device in issue from the other devices formed in the same substrate.

In the operation of the semiconductor device of Fig. 9, when a positive potential is applied to gate electrode 6, p-layer 41 below gate insulating film 3 is inverted to form a channel. Then, electrons (indicated by ⊖ in Fig. 9) flowed out from n⁺-layer 32 reach p⁺-layer 13 through the channel and n⁻-layer 61. This injects holes (indicated by ⊕ in Fig. 9) from p⁺-layer 13 into n⁻-layer 61. Thus, the conductivity of n⁻-layer 61 of high resistance is modulated so as to cause n⁻-layer 61 to have low resistance. Accordingly, the IGBT of Fig. 9 has advantages that its resistance loss is little and also its power consumption is little since it is an insulated gate semiconductor device.

However, the lateral IGBT structure of Fig. 9 has the following disadvantages. Since p⁺-layer 13 is provided only in the substrate surface, the electrons ⊖ flowed out from n⁺-layer 32 and the holes ⊕ injected from p⁺-layer 13 flow only in the lateral direction in n⁻-layer 61. Thus, the conductivity modulation of n⁻-layer 61 occurs only in the neighborhood of its surface so that large current can not flow. Further, since the holes ⊕ flow concentratively in the lateral direction immediately below n⁺-layer 32 so that a potential drop occurs due to the lateral resistance component R in p-layer 41. This potential drop foward-biases n⁺-layer 32 to inject electrons. Thus, a thyristor composed of n⁺-layer 32, p-layer 41, n⁻-layer 61 and p⁺-layer 13 will be turned on (so-called "latch-up" occurs), thereby making it impossible to control current by means of a gate.

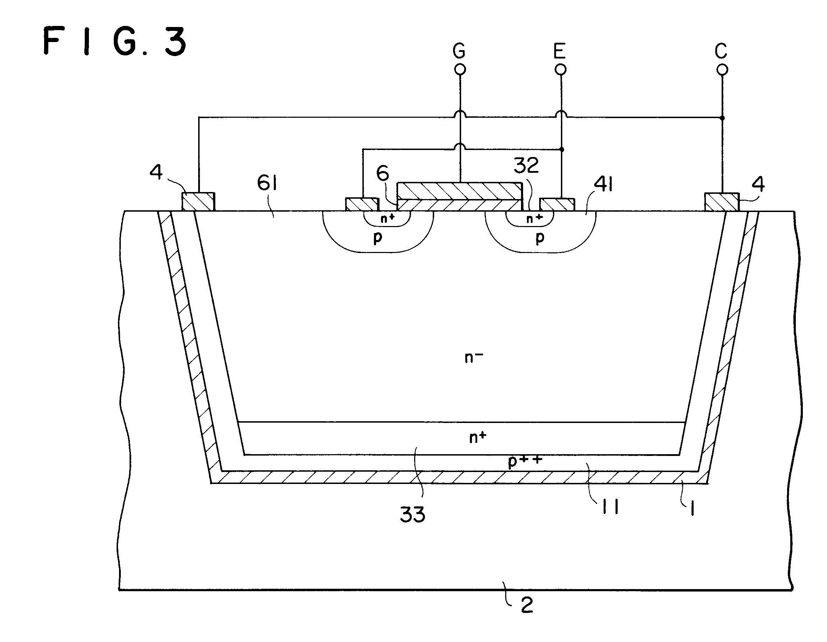

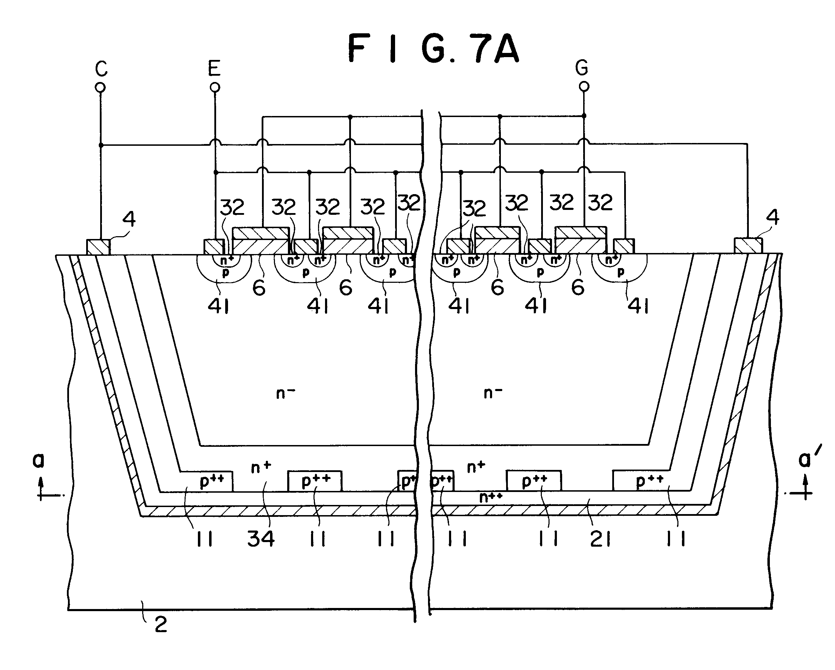

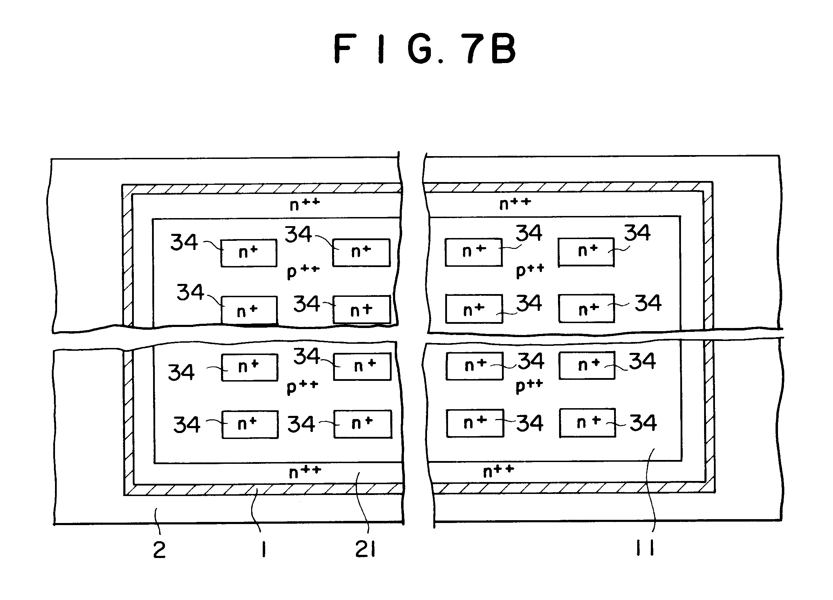

Other conventional devices are disclosed in "Technical Digest IEEDM 85, December 1-4, 1985, pages 724 - 727 (in particular Fig. 7), and "Electro and Mini/Micro Northeast", April 23 - 25, 1985, 24/3 pages 1 - 3 (in particular Fig. 3), in which a p⁺ layer (anode) is located at the same level plane as both a p layer (p well in the latter document) which acts as a channel layer, and an n⁺layer which acts to provide electrons and exists in the p layer. These conventional devices are provided as single crystal island regions formed in the surface of a supporting substrate by a dielectric film, with an n⁺-type buried layer having a portion extending to the surface of said island region and provided adjacent said dielectric film.

### SUMMARY OF THE INVENTION

An object of the present invention is to provide an IGBT structure semiconductor device that can be integrated and permits a large current to uniformly flow therethrough.

The above object can be achieved by adopting a structure in which the direction of a main current in IGBT is changed several times (i.e. the main current flows in the lateral direction in a channel region of IGBT, flows in the vertical direction in a drift region thereof and flows towards one main surface of the substrate in a collector region thereof). In other words, the above object can be attained by a structure that IGBT having a passage through which the main current flows in the vertical direction (vertical with respect to the main surface) is formed within a single crystal island surrounded by an insulating film in the substrate.

The above object is achieved, according to the present invention, by a semiconductor device claimed in claims 1 and 8, respectively.

The semiconductor device in accordance with the present invention has the following advantages. Since a collector region can be formed so as to surround an island-shaped drift region, a main current can be passed in a large amount and uniformly through the drift region in its vertical direction. Moreover, the carriers injected from the collector region flow in the drift region in its vertical direction so that the amount of carriers flowing in the lateral direction below an emitter layer is reduced, thereby obviating the problem of "latch-up".

Further, respective electrodes can be extracted out from one surface of the substrate so that the semiconductor device which can be easily integrated can be provided.

### BRIEF DESCRIPTION OF THE DRAWINGS

Fig. 1 is a vertical sectional view of a first embodiment of the present invention;
Fig. 2 is a vertical sectional view of a second embodiment of the present invention;
Fig. 3 is a vertical sectional view of a modification of the second embodiment;
Fig. 4 is another modification of the second embodiment;
Fig. 5 is still another modification of the second embodiment;
Fig. 6A is a vertical sectional view of a third embodiment of the present invention;
Fig. 6B is a sectional view taken on line a-a' of Fig. 6A;
Fig. 7A is a vertical sectional view of a modification of the third embodiment;
Fig. 7B is a sectional view taken on line a-a' of Fig. 7A;
Fig. 8A is a vertical sectional view of a further modification of the second embodiment of the present invention;
Fig. 8B is a sectional view taken on line a-a' of Fig. 8A; and
Fig. 9 is a vertical sectional view of the prior art of IGBT.

### DESCRIPTION OF THE PREFERRED EMBODIMENTS

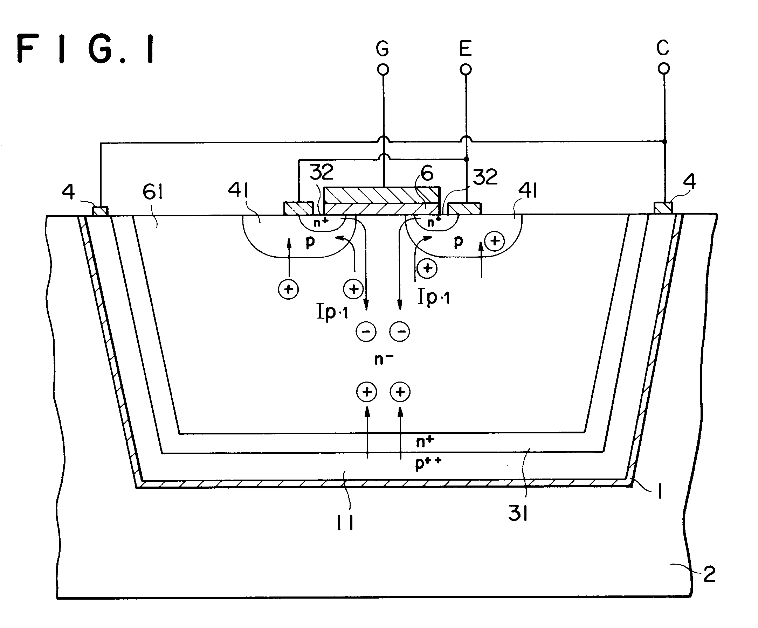

Now referring to the drawings, several embodiments of the present invention will be explained below. Fig. 1 is a vertical sectional view of a first embodiment of the present invention. An n⁻-single-crystal island 61 is formed in a polycrystal semiconductor layer 2 which is a supporting substrate. n⁻-single-crystal island 61 is dielectrically isolated from the other single crystal islands by an electric insulating means, e.g. an insulating film 1 of SiO₂. A p⁺⁺-layer 11 and n⁺ layer 31 are formed between n⁻ single crystal island 61 and inter-layer film 1 so as to surround n⁻ single crystal island 61. A collector electrode 4 is attached to the surface of p⁺⁺ layer 11. A MOS gate consisting n⁺ layers 32, p layers 41 and an insulating film 6 is formed in n⁻ single crystal island 61. If a positive potential is applied to a gate electrode G on gate insulating film 6, p layer 41 immediately below gate insulating film 6 is inverted in its conduction type, and electrons ⊖ flowed out from n⁺ layer 32 drift through n⁻ single crystal island 61 in the vertical direction to reach p⁺⁺ layer 11. Further, the electrons ⊖ flow into p⁺⁺ layer 11 through n⁺ layer 31 so that holes ⊕ are injected from p⁺⁺ layer 11 into n⁺ layer 31, thus producing the conductivity modulation in the device.

The device of Fig. 1 has the following advantages over the conventional lateral IGBT. First, the device of Fig. 1 has a current path through which current flows in the vertical (longitudinal) direction with respect to the substrate main surface. Secondly, the conductivity modulation occurs in the vertical direction so that a large current is permitted to flow uniformly. Thirdly, holes ⊕ flow in the vertical direction so that the hole current laterally flowing through p layer 41 immediately below n⁺ layer 32 is reduced whereby the device is hardly latched up.

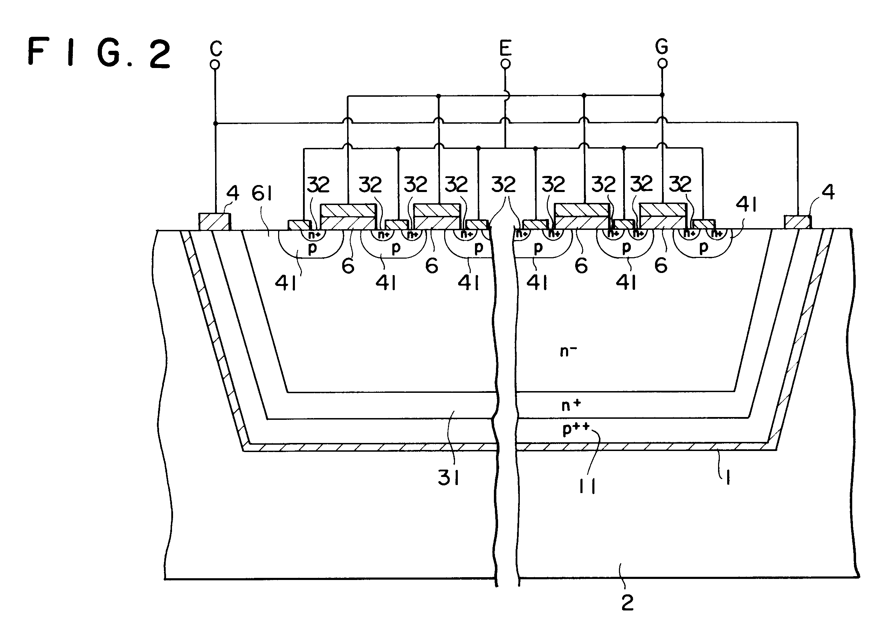

Incidentally, Fig. 1 is a vertical sectional view of an actual device. In the actual device, respective elements (devices) are arranged to be extended in the direction perpendicular to the sheet. Further, a great number of such extended elements are arranged in one single crystal island 61 in such a manner as shown in Figs. 2 and 7A with respect to one single crystal island 61. This applies to the respective embodiments of Figs. 3, 4, 5, 6A and 8A.

Fig. 2 is a vertical sectional view of a second embodiment of the present invention. In Fig. 2, the same reference symbols as in Fig. 1 refer to the same or equivalent parts in Fig. 1. The structure of this embodiment is different from that of Fig. 1 in that p⁺⁺ layer 11 and n⁺ layer 31 are short-circuited by collector electrode 4 in their surface. In this structure, a part of the electrons flowed through n⁻ layer 61 flow into collector 4 via n⁺ layer 31 so that injection of holes from p⁺⁺ layer 11 is restricted thereby preventing the latch-up, and excess electrons can be extracted out from n⁺ layer 31, thereby permitting the device to be turned off at a high speed.

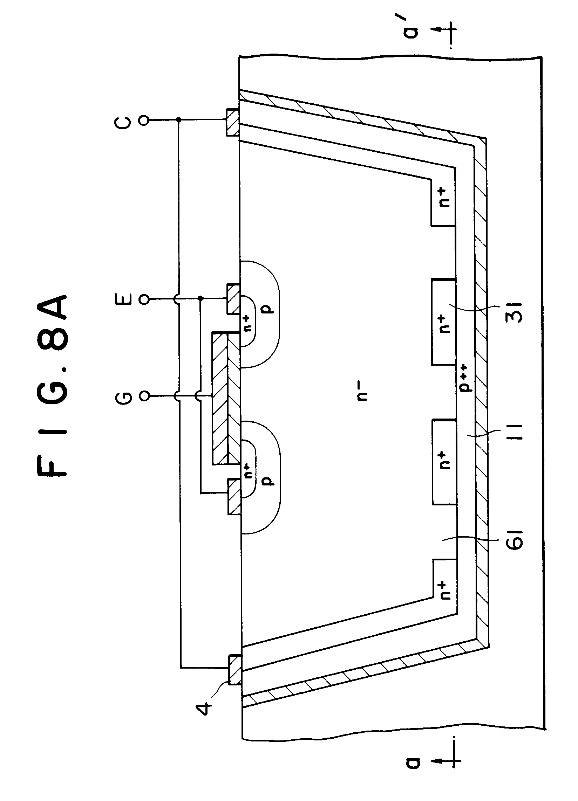

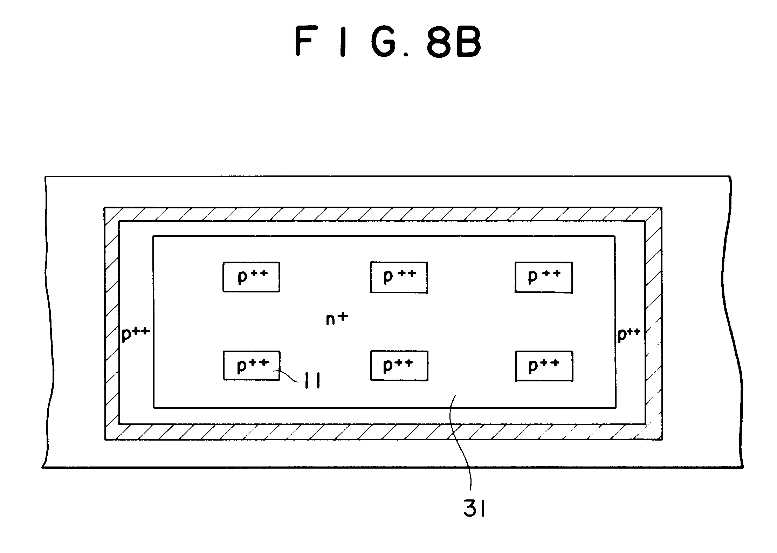

Fig. 8A is a vertical sectional view of a modification of the second embodiment of the present invention. Fig. 8B is a sectional view taken on line a-a′ of Fig. 8A. In Figs. 8A and 8B, the same reference symbols as in Fig. 1 refer to the same or equivalent parts in Fig. 1. The structure of this modification is different from that of the embodiment of Fig. 2 in that n⁺ layer 31 is partially removed so that p⁺ layer 11 and n⁻ single crystal island 61 are partially connected with each other. In Fig. 2, p⁺⁺ layer 11 is completely covered with n⁺ layer 31 so that the injection efficiency of holes from p⁺⁺ layer 11 may be so low as to make the conductivity modulation insufficient. On the other hand, in the modification of Figs. 8A and 8B, n⁺ layer 31 is partially removed so that p⁺⁺ layer 11 and n⁻ single crystal island 61 are partially connected with each other. And the parts of p⁺⁺ layer 11 kept in contact with single crystal island 61, which has a low impurity concentration, provide a high hole injection efficiency. Thus, the modification of Figs. 8A and 8B permit a larger current to flow than in the case where n⁺ layer 31 is formed on the entire p⁺⁺ layer 11.

Fig. 3 is a vertical sectional view of another modification of the second embodiment of the present invention. In Fig. 3, the same reference symbols as in Fig. 1 refer to the same or equivalent parts in Fig. 1. The structure of this modification is different from that of the embodiment of Fig. 2 in that p⁺⁺ layer 11 and n⁻ single crystal island 61 are short-circuited by collector electrode 4 in their surface and also an n⁺ buried layer 33 is short-circuited with p⁺⁺ layer 11 by collector electrode 4 through n⁻ single crystal island 61 in the substrate surface. In the embodiment of Fig. 2, the short-circuiting effect is so great that the injection efficiency of holes is reduced and thus the conductivity modulation may be insufficient. In this modification, n⁺ embedded layer 33 is short-circuited with p⁺⁺ layer 11 by collector electrode 4 through single crystal island 61 which has high resistance so that the amount of the electrons flowing from n⁺ embedded layer 33 to collector electrode 4 is reduced. Thus, the injection of holes from p⁺⁺ layer 11 is increased, thereby permitting a larger current to flow than in the structure of Fig. 2. The same effect can also be obtained by forming a Schottky junction between collector electrode 4 and n⁻ layer 61.

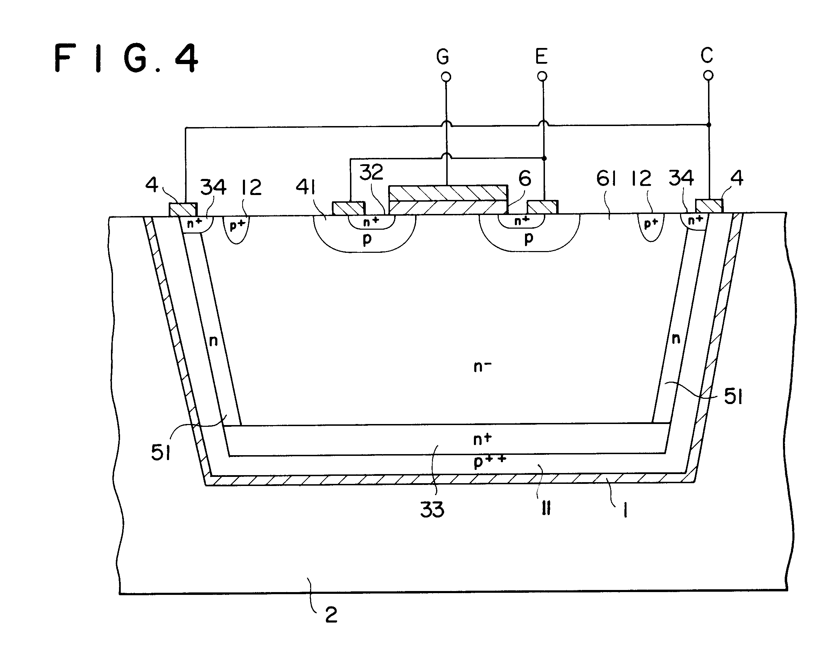

Fig. 4 is a vertical sectional view of still another modification of the second embodiment of the present invention. In Fig. 4, the same reference symbols as in Fig. 1 refer to the same or equivalent parts in Fig. 1. The structure of this modification is different from that of Fig. 3 in that an n⁺ layer 34 and a p⁺ layer 12 are formed in the surface of n⁻ single crystal island 61 and an n layer 51 is formed between n⁺ embedded layer 33 and n⁺ layer 34. The provision of n⁺ layer 34 permits the contact resistance for collector electrode 4 to be reduced. The p⁺ layer 12 formed in the neighborhood of the surface of n⁻ single crystal island 61 permits the electrons directly reaching n⁺ layer 34 to be reduced and the electric field to be reduced. Further, by varying the impurity concentration of n layer 51, the amount of electrons flowing from n⁺ embedded layer 33 to collector electrode 4 via n layer 51 can be varied. More specifically, if the impurity concentration of n layer 51 is increased, the amount of electrons flowing to collector electrode 4 via n layer 51 is increased so that the injection of holes from p⁺ layer 11 can be restricted. By controlling the injection of holes from p⁺⁺ layer 11 in this manner, the switching speed and the current density of the device can be advantageously controlled.

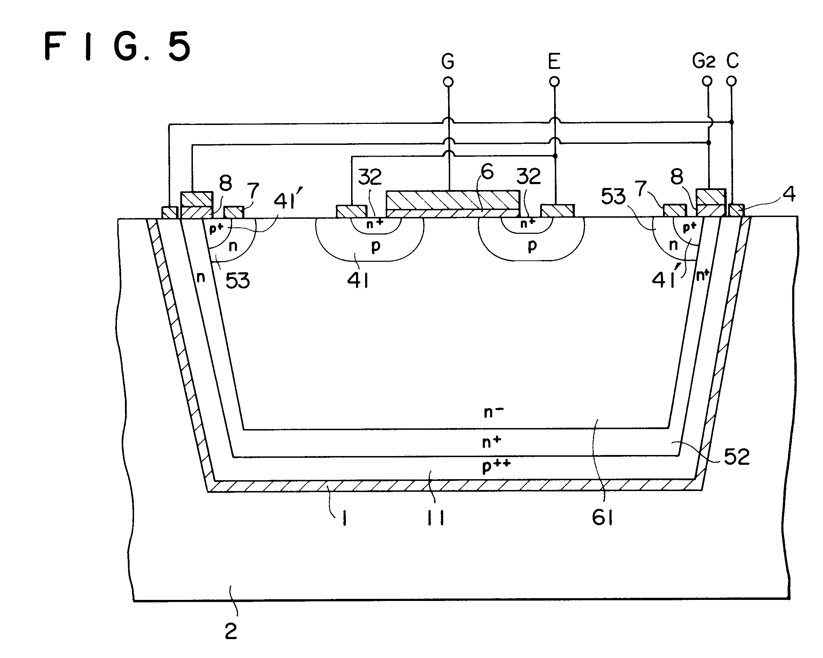

Fig. 5 is a vertical sectional view of a further modification of the second embodiment of the present invention. In Fig. 5, the same reference symbols as in Fig. 1 refer to the same or equivalent parts in Fig. 1. The structure of this modification is different from that of Fig. 2 in that an n⁺ layer 52 in place of n⁺ layer 31 is formed between p⁺⁺ layer 11 and n⁻ single crystal island 61 so as to surround n⁻ single crystal island 61, in that an n layer 53 in contact with n⁺ layer 52 is formed so as to be extended to the surface of n⁻ single crystal island 61 and a p⁺ layer 41' is formed within the n layer 53 so as to be extended to the surface and be in contact with n⁺ layer 52, and in that a gate insulator 8 of an insulating film is provided on the surface of n⁺ layer 52 to be also extended onto p⁺ layer 41 and p⁺⁺ layer 11 and a second gate G₂ is provided by stacking an electrode material on the gate insulator 8. In operation, if a positive potential is applied to the first gate G, electrons flow out from n⁺ layer 32 thereby to turn the device on. On the other hand, if the potential applied to the first gate G is removed, the injection of electrons from n⁺ layer 32 stops. Then, if the second gate G₂ is placed in a lower potential state than the collector electrode, the polarity of n⁺ layer 52 below gate insulator 8 is inverted. Thus, p⁺ layer 41' is short-circuited with p⁺⁺ layer 11 so that electrons can be extracted from n⁻ single crystal island 61 through n layer 53, a short-circuiting electrode 7, p⁺ layer 41', n⁺ layer 52, p⁺⁺ layer 11 and the collector electrode 4, which permits the device to be turned off at a high speed. In this way, in turning off the IGBT device, the electrons are extracted by placing the second gate G₂ in the conduction state so that the device can be turned off at a high speed.

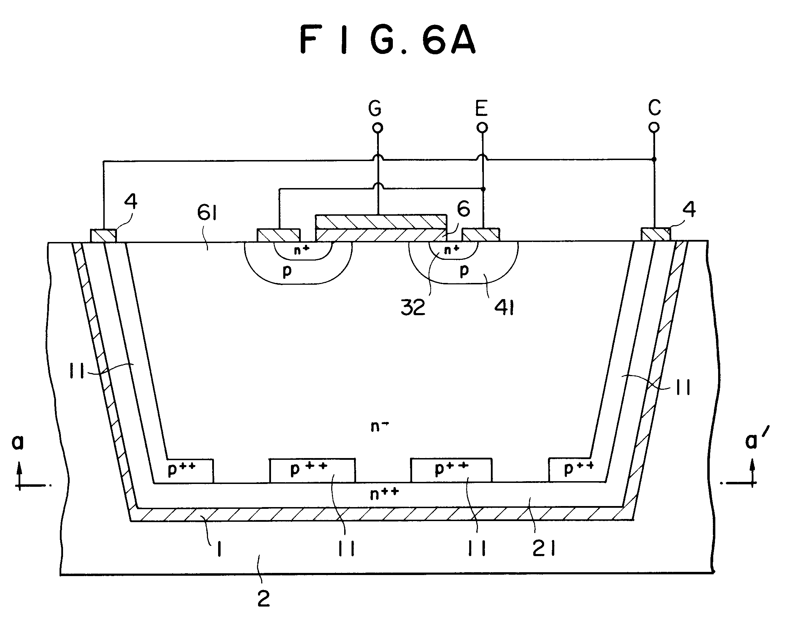

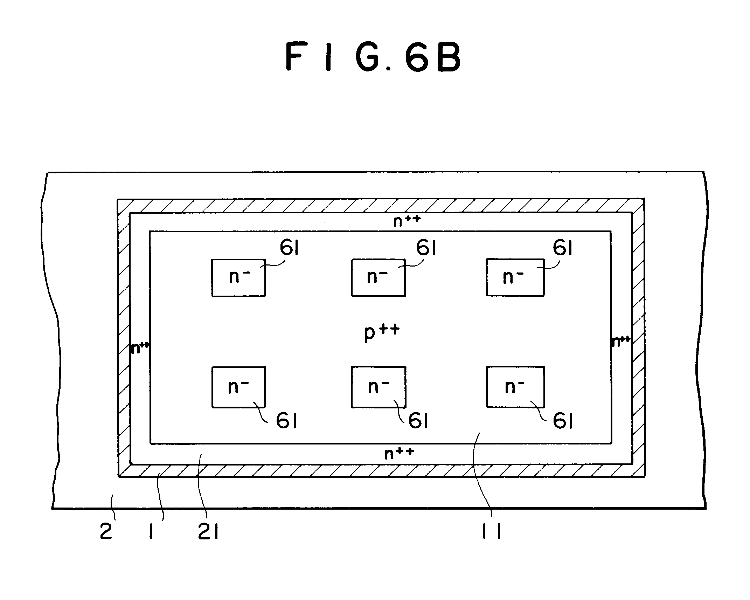

Fig. 6A is a vertical sectional view of a third embodiment of the present invention. Fig. 6B is a sectional view taken on line a-a′ of Fig. 6A. In Figs. 6A and 6B, the same reference symbols as in Fig. 1 refer to the same or equivalent parts in Fig. 1. In this embodiment, an n⁺⁺ short-circuiting layer 21 and p⁺⁺ layer 11 are formed from inter-layer insulating film 1 toward n⁻ single crystal island 61. n⁺⁺ short-circuiting layer 21 and p⁺⁺ layer 11 are short-circuited by collector electrode 4 in their surface. Further, p⁺⁺ layer 11 is partially removed so that n⁺⁺ short-circuiting layer 21 and n⁻ single crystal island 61 are partially kept in contact with each other. Thus, by varying the area where n⁺⁺ short-circuiting layer 21 and n⁻ single crystal island 61 are kept in contact with each other, the amount of electrons flowing from n⁻ single crystal island 61 to collector electrode 4 via n⁺⁺ short-circuiting layer 21 is varied so that the amount of holes injected from p⁺⁺ layer 11 can be controlled. Further, the n⁺⁺ short-circuiting layer 21 formed immediately below the gate electrode G, which serves to extract electrons, permits a current to uniformly flow in the vertical direction and hence a large current to flow. This also prevents the device from being latched up.

Fig. 7A is a vertical sectional view of a modification of the third embodiment of the present invention. Fig. 7B is a sectional view taken on line a-a' of Fig. 7A. In Figs. 7A and 7B, the same reference symbols as in Fig. 1 refer to the same or equivalent parts in Fig. 1. In this embodiment, an n⁺ layer 34 is formed between p⁺⁺ layer 11 and n⁻ single crystal island 61. The p⁺⁺ layer 11 is partially removed so that n⁻ single crystal island 61 is short-circuited with p⁺⁺ layer 11 through n⁺ layer 34 and n⁺⁺ short-circuiting layer 21. The provision of n⁺ layer 34 serves to shorten the lifetime of minority carriers thereby enhancing the switching speed, and also prevent the depletion layer from punch-through effect in p⁺⁺ layer 11 to reduce the breakdown voltage.

It goes without saying that in the several embodiments as explained above, replacing the conduction type of each layer (from the n type to the p type and vice versa) gives the same effect.

In the above explanation, the n⁻ layer, n layer, n+ layer and n⁺⁺ layer denote n-type layers which have a higher impurity concentration in this order. Likewise, the p⁻ layer, p layer, p⁺ layer and p⁺⁺ layer denote p-type layers which have a higher impurity concentration in this order.

The typical doping concentration (the number of dopant atoms per a unit volume 1 cm³) of each of the layers are roughly as follows.
(1) The p⁺⁺ layer which serves as a collector layer: 1 x 10¹⁸ - 1 x 10²⁰ ;
(2) The active base region (the n⁻ single crystal island which serves as a drift region): 1 x 10¹³ - 5 x 10¹⁵ ;
(3) The p layer which serves as a shield base region (channel): 1 x 10¹⁵ - 5 x 10¹⁸ ;
(4) The n⁺ layer which serves as a cathode region (emitter region): larger than 1 x 10¹⁹.

Although in the above explanation of the respective embodiments, the so-called dielectric isolation substrate using a polycrystal silicon as a supporting substrate has been used, any other structure may be used as long as isolation between the single crystal islands is maintained. Further, a plurality of single crystal islands may be formed on the supporting substrate, and the device of the present invention and the other function devices may be formed in each single crystal island so that an IC (integrated circuit) for a large current is constituted.

As understood from the above explanation, in accordance with the present invention, IGBT can be formed within a semiconductor island surrounded by an insulating film and dielectrically isolated from the other islands so that current can flow in the vertical direction. This permits a current to uniformly flow in the vertical direction and hence a large current to flow. Further, the amount of holes traversing the short-circuiting resistance of the n⁺ layer can be reduced so that the latch-up can be prevented. Moreover, short-circuiting the p layer and n layer formed in the collector layer by the collector electrode permits the device to be operated at a high speed.

The present invention is summarized as follows. A dielectric isolation substrate is used as a supporting substrate. An island-shaped second semiconductor region of a second conductivity type is formed so as to be surrounded by an insulator and a first semiconductor layer of a first conductivity type. An FET having an insulated gate is formed in the second semiconductor region. A collector electrode is attached to the first semiconductor layer.

In accordance with the present invention, a semiconductor device which is suitable for integration and can perform a switching operation of a large electric power can be provided.

## Claims

1. A semiconductor device comprising:
a supporting substrate (2);
a plurality of single crystal island regions which are formed in the surface of said supporting substrate (2) by a dielectric film (1);
a first region (61) of one conductivity type formed in the surface of each of said island regions;
a second region (41) of the other conductivity type formed within said first region (61) and having a higher impurity concentration than said first region (61), said second region (41) forming a first pn junction with said first region (61);
a third region (32) of one conductivity type formed within said second region (41) and having a higher impurity concentration than said second region (41), said third region (32) forming a second pn junction with said second region (41);
a fourth region (11) of the other conductivity type located between said first region (61) and said dielectric film (1) and having a higher impurity concentration than said first region (61), said fourth region (11) having a portion extending to the surface of said island region;
a first main electrode (E) located on said island region surface and in ohmic contact with said second and third regions (41, 32);
a second main electrode (C) located on said island region surface and in ohmic contact with the exposed surface of said fourth region (11); and
a control electrode (G) located on an insulating film (6) provided on said island surface and extending over said first, second and third regions (61, 41, 32).

2. A semiconductor device according to claim 1, further comprising a fifth region (31, 52) of one conductivity type formed between said first region (61) and said fourth region (11) and having an impurity concentration higher than said first region (61) and lower than said fourth region (11).

3. A semiconductor device according to claim 2, further comprising,
a sixth region (53) of one conductivity type being in contact with said fifth region (52) and exposed to said island region surface, said sixth region (53) having a higher impurity concentration than said first region (61);
a seventh region (41') of the other conductivity type formed within said sixth region (53) so as to be in contact with said fifth region (52) and to be exposed to said island region surface, said seventh region (41') having a higher impurity concentration than said sixth region (53);
a second control electrode (G₂) located on an insulator (8) provided on said island region surface and extending over said fourth region (11), said fifth region (52) and said seventh region (41'); and
a short circuiting electrode (7) located on said island region surface and in ohmic contact with said sixth region (53) and said seventh region (41').

4. A semiconductor device according to claim 1,
wherein said second main electrode (C) is also in ohmic contact with the exposed surface of said first region (61).

5. A semiconductor device according to claim 4, further comprising a fifth region (33) of one conductivity type formed between said first region (61) and said fourth region (11) so as to be located at only the bottom of said island region and having an impurity concentration higher than said first region (61) and lower than said fourth region (11).

6. A semiconductor device according to claim 2,
wherein said fifth region (31) has a portion extending to the surface of said island region; and
said second main electrode (C) is also in ohmic contact with the exposed surface of said fifth region (31).

7. A semiconductor device according to claim 6,
wherein said fifth region (31) is selectively removed at several portions of the bottom of said island region where said first region (61) and said fourth region (11) are adjacent to each other.

8. A semiconductor device comprising:
a supporting substrate (2);
a plurality of single crystal island regions which are formed in the surface of said supporting substrate (2) by a dielectric film (1);
a first region (61) of one conductivity type formed in the surface of each of said island regions;
a second region (41) of the other conductivity type formed in the surface of said first region and having a higher impurity concentration than said first region (61), said second region (41) forming a first pn junction with said first region (61);
a third region (32) of one conductivity type formed within said second region (41) and having a higher impurity concentration than said second region (41), said third region (32) forming a second pn junction with said second region (41);
a fourth region (21) of one conductivity type located between said first region (61) and said dielectric film (1) and having a higher impurity concentration than said first region (61), said fourth region (21) having a portion extending to the surface of said island region;
a fifth region (11) of the other conductivity type located between said first region (61) and said fourth region (21) and having a higher impurity concentration than said first region (61), said fifth region (11) having a portion extending to said island region surface and being selectively removed at several portions of the bottom of said island region where said first region (61) and said fourth region (21) are adjacent to each other;
a first main electrode (E) located on said island region surface and in ohmic contact with said second and third regions (41, 32);
a second main electrode (C) located on said island region surface and in ohmic contact with the exposed surfaces of said fourth region (21) and said fifth region (11); and
a control electrode (G) located on an insulating film (6) provided on said island region surface and extending over said first, second and third regions (61, 41, 32).

## Patentansprüche

1. Halbleiteranordnung, die aufweist:
ein Trägersubstrat (2);
eine Mehrzahl von Einkristallinselbereichen, die in der Oberfläche des Trägersubstrats (2) durch einen dielektrischen Film (1) gebildet sind;
einen ersten, in der Oberfläche jedes der Inselbereiche gebildeten Bereich (61) eines Leitfähigkeitstyps;
einen zweiten Bereich (41) des anderen Leitfähigkeitstyps, der innerhalb des ersten Bereiches (61) gebildet ist und eine höhere Verunreinigungskonzentration als der erste Bereich (61) hat, welcher zweite Bereich (41) einen ersten pn-Übergang mit dem ersten Bereich (61) bildet;
einen dritten Bereich (32) des einen Leitfähigkeitstyps, der innerhalb des zweiten Bereiches (41) gebildet ist und eine höhere Verunreinigungskonzentration als der zweite Bereich (41) hat, welcher dritte Bereich (32) einen zweiten pn-Übergang mit dem zweiten Bereich (41) bildet;
einen vierten Bereich (11) des anderen Leitfähigkeitstyps, der zwischen dem ersten Bereich (61) und dem dielektrischen Film (1) angeordnet ist und eine höhere Verunreinigungskonzentration als der erste Bereich (61) hat, welcher vierte Bereich (11) einen bis zur Oberfläche des Inselbereichs erstreckten Teil hat;
eine auf der Inselbereichsoberfläche und in ohmischem Kontakt mit den zweiten und dritten Bereichen (41, 32) angeordnete erste Hauptelektrode (E);
eine auf der Inselbereichsoberfläche und in ohmischem Kontakt mit der freiliegenden Oberfläche des vierten Bereiches (11) angeordnete zweite Hauptelektrode (C); und
eine Steuerelektrode (G), die auf einem auf der Inseloberfläche vorgesehenen Isolierfilm (6) mit Erstreckung über die ersten, zweiten und dritten Bereiche (61, 41, 32) angeordnet ist.

2. Halbleiteranordnung nach Anspruch 1,
die weiter einen fünften Bereich (31, 52) des einen Leitfähigkeitstyps aufweist, der zwischen dem ersten Bereich (61) und dem vierten Bereich (11) gebildet ist und eine Verunreinigungskonzentration hat, die höher als die des ersten Bereichs (61) und niedriger als die des vierten Bereiches (11) ist.

3. Halbleiteranordnung nach Anspruch 2,
die weiter aufweist:
einen sechsten Bereich (53) des einen Leitfähigkeitstyps, der im Kontakt mit dem fünften Bereich (52) ist und an der Inselbereichsoberfläche freiliegt, welcher sechste Bereich (53) eine höhere Verunreinigungskonzentration als der erste Bereich (61) hat,
einen siebenten Bereich (41') des anderen Leitfähigkeitstsyps, der innerhalb des sechsten Bereichs (53) so gebildet ist, daß er im Kontakt mit dem fünften Bereich (52) ist und an der Inselbereichsoberfläche freiliegt, welcher siebente Bereich (41') eine höhere Verunreinigungskonzentration als der sechste Bereich (53) hat;
eine zweite Steuerelektrode (G₂), die auf einem auf der Inselbereichsoberfläche vorgesehenen Isolator (8) mit Erstreckung über den vierten Bereich (11), den fünften Bereich (52) und dem siebenten Bereich (41') angeordnet ist; und
eine kurzschließende Elektrode (7), die auf der Inselbereichsoberfläche angeordnet und in ohmischem Kontakt mit dem sechsten Bereich (53) und dem siebenten Bereich (41') ist.

4. Halbleiteranordnung nach Anspruch 1, in der die zweite Hauptelektrode auch in ohmischem Kontakt mit der freiliegenden Oberfläche des ersten Bereichs (61) ist.

5. Halbleiteranordnung nach Anspruch 4,
die weiter einen fünften Bereich (33) des einen Leitfähigkeitstyps aufweist, der zwischen dem ersten Bereich (61) und dem vierten Bereich (11) so gebildet ist, daß er nur am Boden des Inselbereichs liegt, und eine Verunreinigungskonzentration hat, die höher als die des ersten Bereiches (61) und niedriger als die des vierten Bereiches (11) ist.

6. Halbleiteranordnung nach Anspruch 2,
in der der fünfte Bereich (31) einen sich zur Oberfläche des Inselbereichs erstreckenden Teil hat; und die zweite Hauptelektrode (C) auch in ohmischem Kontakt mit der freiliegenden Oberfläche des fünften Bereichs (31) ist.

7. Halbleiteranordnung nach Anspruch 6,
in der der fünfte Bereich (31) an einigen Stellen des Bodens des Inselbereichs selektiv entfernt ist, wo der erste Bereich (61) und der vierte Bereich (11) aneinandergrenzen.

8. Halbleiteranordnung, die aufweist:
ein Trägersubstrat (2);
eine Mehrzahl von Einkristallinselbereichen, die in der Oberfläche des Trägersubstrats (2) durch einen dielektrischen Film (1) gebildet sind;
einen ersten, in der Oberfläche jedes der Inselbereiche gebildeten Berich (61) eines Leitfähigkeitstyps;
einen zweiten Bereich (41) des anderen Leitfähigkeitstyps, der innerhalb des ersten Bereiches (61) gebildet ist und eine höhere Verunreinigungskonzentration als der erste Bereich (61) hat, welcher zweite Bereich (41) einen ersten pn-Übergang mit dem ersten Bereich (61) bildet;
einen dritten Bereich (32) des einen Leitfähigkeitstyps, der innerhalb des zweiten Bereiches (41) gebildet ist und eine höhere Verunreinigungskonzentration als der zweite Bereich (41) hat, welcher dritte Bereich (32) einen zweiten pn-Übergang mit dem zweiten Bereich (41) bildet;
einen vierten Bereich (21) des einen Leitfähigkeitstyps, der zwischen dem ersten Bereich (61) und dem dielektrischen Film (1) angeordnet ist und eine höhere Verunreinigungskonzentration als der erste Bereich (61) hat, welcher vierte Bereich (21) einen bis zur Oberfläche des Inselbereichs erstreckten Teil hat;
einen fünften Bereich (11) des anderen Leitfähigkeitstyps, der zwischen dem ersten Bereich (61) und dem vierten Bereich angeordnet ist und eine höhere Verunreinigungskonzentration als der erste Bereich (61) hat, welcher fünfte Bereich (11) einen sich zur Inselbereichsoberfläche erstreckenden Teil hat und an einigen Teilen des Bodens des Inselbereichs selektiv entfernt ist, wo der erste Bereich (61) und der vierte Bereich (21) aneinandergrenzen;
eine auf der Inselbereichsoberfläche und in ohmischem Kontakt mit den zweiten und dritten Bereichen (41, 32) angeordnete erste Hauptelektrode (E);
eine auf der Inselbereichsoberfläche und in ohmischem Kontakt mit den freiliegenden Oberflächen des vierten Bereichs (21) und des fünften Bereichs (11) angeordnete zweite Hauptelektrode (C); und
eine Steuerelektrode (G), die auf einem auf der Inselbereichsoberfläche vorgesehenen Isolierfilm (6) mit Erstreckung über die ersten, zweiten und dritten Bereiche (61, 41, 32) angeordnet ist.

## Revendications

1. Dispositif à semiconducteur comprenant :
un substrat de support (2) ;
une pluralité de régions d'îlot monocristallin qui sont formées dans la surface dudit substrat de support (2) par une pellicule diélectrique (1) ;
une première région (61), d'un premier type de conductivité, formée dans la surface de chacune desdites régions d'îlot ;
une deuxième région (41), de l'autre type de conductivité, formée à l'intérieur de ladite première région (61) et possédant une concentration en impureté supérieure à celle de ladite première région (61), ladite deuxième région (41) formant une première jonction pn avec ladite première région (61) ;
une troisième région (32), du premier type de conductivité, formée à l'intérieur de ladite deuxième région (41) et possédant une concentration en impureté supérieure à celle de ladite deuxième région (41), ladite troisième région (32) formant une deuxième jonction pn avec ladite deuxième région (41) ;
une quatrième région (11), de l'autre type de conductivité, située entre ladite première région (61) et ladite pellicule diélectrique (1) et possédant une concentration en impureté supérieure à celle de ladite première région (61), ladite quatrième région (11) possédant une partie qui s'étend jusqu'à la surface de ladite région d'îlot ;
une première électrode principale (E) située sur la surface de ladite région d'îlot et en contact ohmique avec lesdites deuxième et troisième régions (41, 32) ;
une deuxième électrode principale (C) située sur la surface de ladite région d'îlot et en contact ohmique avec la surface exposée de ladite quatrième région (11) ; et
une électrode de commande (G) située sur une pellicule isolante (6) qui est placée sur ladite surface d'îlot et s'étendant au-dessus desdites première, deuxième et troisième régions (61, 41, 32).

2. Dispositif à semiconducteur selon la revendication 1, comprenant en outre une cinquième région (31, 52), du premier type de conductivité, formée entre ladite première région (61) et ladite quatrième région (11) et possédant une concentration en impureté supérieure à celle de ladite première région (61) et inférieure à celle de ladite quatrième région (11).

3. Dispositif à semiconducteur selon la revendication 2, comprenant en outre :
une sixième région (53), du premier type de conductivité, qui est en contact avec ladite cinquième région (52) et est exposée à la surface de ladite région d'îlot, ladite sixième région (53) ayant une concentration en impureté supérieure à celle de ladite première région (61) ;
une septième région (41'), de l'autre type de conductivité, formée à l'intérieur de ladite sixième région (53) de façon à se trouver en contact avec ladite cinquième région (52) et à être exposée à la surface de ladite région d'îlot, ladite septième région (41') ayant une concentration en impureté supérieure à celle de ladite sixième région (53) ;
une deuxième électrode de commande (G₂) située sur un isolant (8) qui est placé sur la surface de ladite région d'îlot et s'étendant au-dessus de ladite quatrième région (11), de ladite cinquième région (52) et de ladite septième région (41') ; et
une électrode de court-circuit (7) située sur la surface de ladite région d'îlot et en contact ohmique avec ladite sixième région (53) et ladite septième région (41').

4. Dispositif à semiconducteur selon la revendication 1, où ladite deuxième électrode principale (C) est également en contact ohmique avec la surface exposée de ladite première région (61).

5. Dispositif à semiconducteur selon la revendication 4, comprenant en outre une cinquième région (33), du premier type de conductivité, formée entre ladite première région (61) et ladite quatrième région (11) de façon à être située à la partie inférieure seulement de ladite région d'îlot et ayant une concentration en impureté supérieure à celle de ladite première région (61) et inférieure à celle de ladite quatrième région (11).

6. Dispositif à semiconducteur selon la revendication 2, où ladite cinquième région (31) possède une partie qui s'étend jusqu'à la surface de ladite région d'îlot ; et
ladite deuxième électrode principale (C) est également contact ohmique avec la surface exposée de ladite cinquième région (31).

7. Dispositif à semiconducteur selon la revendication 6, où ladite cinquième région (31) a été sélectivement retirée en plusieurs endroits de la partie inférieure de ladite région d'îlot où ladite première région (61) et ladite quatrième région (11) sont adjacentes l'une à l'autre.

8. Dispositif à semiconducteur comprenant :
un substrat de support (2) ;
une pluralité de régions d'îlot monocristallin qui sont formées dans la surface dudit substrat de support (2) par une pellicule diélectrique (1) ;
une première région (61), d'un premier type de conductivité, formée dans la surface de chacune desdites régions d'îlot ;
une deuxième région (41), de l'autre type de conductivité, formée dans la surface de ladite première région et possédant une concentration en impureté supérieure à celle de ladite première région (61), ladite deuxième région (41) formant une première jonction pn avec ladite première région (61) ;
une troisième région (32), du premier type de conductivité, formée à l'intérieur de ladite deuxième région (41) et possédant une concentration en impureté supérieure à celle de ladite deuxième région (41), ladite troisième région (32) formant une deuxième jonction pn avec ladite deuxième région (41) ;
une quatrième région (21), du premier type de conductivité, située entre ladite première région (61) et ladite pellicule diélectrique (1) et possédant une concentration en impureté supérieure à celle de ladite première région (61), ladite quatrième région (21) possédant une partie qui s'étend jusqu'à la surface de ladite région d'îlot ;
une cinquième région (11), de l'autre type de conductivité, située entre ladite première région (61) et ladite quatrième région (21) et ayant une concentration en impureté supérieure à celle de ladite première région (61), ladite cinquième région (11) possédant une partie qui s'étend jusqu'à la surface de ladite région d'îlot et ayant été sélectivement retirée en plusieurs endroits de la partie inférieure de ladite région d'îlot où ladite première région (61) et ladite quatrième région (21) sont adjacentes l'une à l'autre;
une première électrode principale (E) située sur la surface de ladite région d'îlot et en contact ohmique avec lesdites deuxième et troisième régions (41, 32);
une deuxième électrode principale (C) située sur la surface de ladite région d'îlot et en contact ohmique avec les surfaces exposées de ladite quatrième région (21) et de ladite cinquième région (11) ; et
une électrode de commande (G) située sur une pellicule isolante (6) qui est placée sur la surface de ladite région d'îlot et s'étendant au-dessus desdites première, deuxième et troisième régions (61, 41, 32).
